(19) Europäisches Patentamt
European Patent Office
Office européen des brevets

(11) **EP 2 191 548 B1**

(12) **EUROPÄISCHE PATENTSCHRIFT**

(45) Veröffentlichungstag und Bekanntmachung des Hinweises auf die Patenterteilung:
**30.09.2015 Patentblatt 2015/40**

(21) Anmeldenummer: **08801200.0**

(22) Anmeldetag: **18.08.2008**

(51) Int Cl.:
*H01S 5/20* *(2006.01)*     *H01S 5/00* *(2006.01)*
*H01S 5/10* *(2006.01)*     *H01S 5/22* *(2006.01)*
*H01S 5/30* *(2006.01)*     *H01S 5/40* *(2006.01)*

(86) Internationale Anmeldenummer:
**PCT/DE2008/001377**

(87) Internationale Veröffentlichungsnummer:
**WO 2009/039808 (02.04.2009 Gazette 2009/14)**

(54) **STRAHLUNGSEMITTIERENDES BAUELEMENT**

RADIATION-EMITTING COMPONENT

ÉLÉMENT RAYONNANT

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **24.09.2007 DE 102007045499**
**26.10.2007 DE 102007051315**

(43) Veröffentlichungstag der Anmeldung:
**02.06.2010 Patentblatt 2010/22**

(73) Patentinhaber: **OSRAM Opto Semiconductors GmbH**
**93055 Regensburg (DE)**

(72) Erfinder: **BRICK, Peter**
**93051 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:
JP-A- 5 251 813     US-A- 5 073 041
US-A- 5 815 521

- **SHUN TUNG YEN ET AL: "Theoretical Investigation on Semiconductor Lasers with Passive Waveguides" IEEE JOURNAL OF QUANTUM ELECTRONICS, IEEE SERVICE CENTER, PISCATAWAY, NJ, USA, Bd. 32, Nr. 1, 1. Januar 1996 (1996-01-01), XP011051295 ISSN: 0018-9197**
- **GUPTA: "Section 7.2 Semiconductor Diode Lasers ED - Gupta M C" 1. Januar 1997 (1997-01-01), HANDBOOK OF PHOTONICS, CRC PRESS, PAGE(S) 292 - 298 , XP009114823 ISBN: 978-0-8493-8909-2 Seite 296 - Seite 298**
- **FREUDE, W. ET AL: "Refractive-index profile determination of single-mode-fibres by far-field power measurements at 1300 nm" ELECTRONICS LETTERS, Bd. 18, Nr. 18, 28. August 1986 (1986-08-28), Seiten 945-947, XP009114990**

**Beschreibung**

Das vorliegende Patent betrifft ein strahlungsemittierendes Bauelement.

Bei Halbleiterlasern, die als Pumplaser eingesetzt werden, ist eine Abstrahlung der Laserstrahlung mit einem möglichst homogenen Fernfeld wünschenswert. Typischerweise emittieren Halbleiterlaser jedoch Strahlung mit einem Gauß-ähnlichen Fernfeld. Ausgehend von einer Mittelachse des Strahlungsprofils fällt die Strahlungsintensität also nach außen vergleichsweise schnell ab.

Aus der Druckschrift US 5,815,521 ist ein Halbleiterlaser mit einer geringen Strahldivergenz bekannt. Hierfür sind modenformende Schichten vorgesehen, die in den oberen und unteren Mantelschichten angeordnet sind.

In der Druckschrift JP 05-251813 wird ein Halbleiterlaser beschrieben, bei dem eine zweite Mantelschicht einen größeren Brechungsindex aufweist als eine erste Mantelschicht. Dadurch sollen Fernfeldmuster reduziert werden.

Eine theoretische Untersuchung von Halbleiterlasern mit passiven Wellenleitern wird in dem Artikel vpm S. T. Yen et al. in IEEE Journal of Quantum Electronics, VOL. 32, No. 1 (Januar 1996) angegeben.

Eine Aufgabe ist es, einen Laser anzugeben, der eine verbesserte Homogenität der abgestrahlten Strahlung im Fernfeld aufweisen.

Diese Aufgabe wird durch ein strahlungsemittierendes Bauelement gemäß Patentanspruch 1 gelöst. Vorteilhafte Ausgestaltungen und Weiterbildungen sind Gegenstand der abhängigen Patentansprüche.

Weiterhin wird zur Erläuterung ein in den Patentansprüchen nicht beanspruchtes Verfahren zur Herstellung eines strahlungsemittierenden Bauelements angegeben.

Bei dem Verfahren wird zur Herstellung eines strahlungsemittierenden Bauelements eine Abstrahlcharakteristik im Fernfeld vorgegeben. In einer senkrecht zu einer Hauptabstrahlungsrichtung des Bauelements verlaufenden Richtung wird aus der vorgegebenen Abstrahlcharakteristik ein Brechungsindexprofil ermittelt. Für das Bauelement wird ein Aufbau ermittelt, sodass das Bauelement das zuvor bestimmte Brechungsindexprofil aufweist. Das Bauelement wird gemäß dem zuvor bestimmten Aufbau ausgebildet.

Das Brechungsindexprofil des Bauelements wird also gezielt an eine vorgegebene Abstrahlcharakteristik im Fernfeld angepasst ausgebildet. Auf diese Weise kann beispielsweise eine Abstrahlcharakteristik im Fernfeld mit einer besonders hohen Homogenität erzielt werden. Es kann also bereits die Homogenität der aus dem strahlungsemittierenden Bauelement austretenden Strahlung verbessert werden. Auf ein nachfolgendes Homogenisieren, etwa mittels externer so genannter Homogenisatoren, kann verzichtet werden. Auch ein nachfolgendes Selektieren eines Teilbereichs eines Gauß-ähnlichen Profils, in dem die Homogenität hinreichend hoch ist, ist nicht erforderlich.

Bevorzugt wird aus der vorgegebenen Abstrahlcharakteristik im Fernfeld das zugehörige Nahfeld ermittelt. Dies erfolgt vorzugsweise mittels einer Fourier-Transformation, bei der aus dem Fernfeld das zugehörige Nahfeld hervorgeht.

Im Zweifel wird unter dem Fernfeld das elektromagnetische Feld der abgestrahlten Strahlung in einem Abstand vom strahlungsemittierenden Bauelement, insbesondere von einem zur Erzeugung von Strahlung vorgesehenen aktiven Bereich, angesehen, der groß ist im Vergleich zu der Wellenlänge der abgestrahlten Strahlung.

Im Unterschied zum Fernfeld bewirkt das Nahfeld eine Wechselwirkung mit dem zur Erzeugung von Strahlung vorgesehenen aktiven Bereich des strahlungsemittierenden Bauelements.

In einer bevorzugten Ausgestaltung wird das Brechungsindexprofil aus dem Nahfeld ermittelt. Für den Brechungsindex n gilt hierbei die Proportionalitätsbeziehung

$$n \sim [(n_{eff}^2\, k^2\, E_N(z) - E_N{}''(z))/(k^2\, E_N(z))]^{1/2}$$

wobei die z-Achse senkrecht zu der Hauptabstrahlungsrichtung des Bauelements verläuft, $E_N(z)$ das elektromagnetische Feld des Nahfelds und $E_N''(z)$ die zweite Ableitung elektromagnetischen Felds des Nahfelds $E_N$ ist. k ist hierbei der Wellenvektor der elektromagnetischen Strahlung, $n_{eff}$ ist der effektive Brechungsindex.

In einer bevorzugten Ausgestaltung wird ein Halbleiterkörper mit einer Halbleiterschichtenfolge abgeschieden, wobei die Halbleiterschichtenfolge den zur Erzeugung von Strahlung vorgesehenen aktiven Bereich aufweist. Weiterhin bevorzugt verläuft das Brechungsindexprofil zumindest teilweise innerhalb des Halbleiterkörpers mit der Halbleiterschichtenfolge.

In einer weiteren bevorzugten Ausgestaltung wird das Brechungsindexprofil mittels einer geeigneten Materialzusammensetzung entlang einer Abscheiderichtung für die Halbleiterschichtenfolge des Halbleiterkörpers ausgebildet. Bevorzugt enthalten die Halbleiterschichten der Halbleiterschichtenfolge zumindest teilweise einen ternären, quaternären oder quinternären Verbindungshalbleiter. Bei derartigen Verbindungshalbleitern ist der Brechungsindex des Materials auf einfache Weise mittels der Materialzusammensetzung einstellbar. Durch Abscheiden von Halbleiterschichten mit unterschiedlichen Brechungsindizes kann also das ermittelte Brechungsindexprofil ausgebildet werden. Der Brechungsindex innerhalb einer Halbleiterschicht muss hierbei nicht notwendigerweise konstant sein. Beispielsweise kann der Brechungsindex einer Halbleiterschicht auch einen Gradienten aufweisen oder stufenförmig ab- oder zunehmen.

In einer weiteren bevorzugten Ausgestaltung wird die Abstrahlcharakteristik im Fernfeld entlang zweier schräg oder senkrecht zueinander stehenden Achsen vorgegeben. Basierend auf der vorgegebenen Abstrahlcharakteristik kann senkrecht zu der Hauptabstrahlungsrichtung und schräg oder senkrecht zu dem Brechungsindexprofil ein weiteres Brechungsindexprofil ermittelt werden. Hierbei verläuft das Brechungsindexprofil parallel zur ersten Achse und das weitere Brechungsindexprofil parallel zur zweiten Achse. Nachfolgend kann der Aufbau des Bauelements derart ermittelt werden, dass das Bauelement das zuvor bestimmte weitere Brechungsindexprofil aufweist.

Hierbei kann das weitere Brechungsindexprofil ebenfalls gemäß der im Zusammenhang mit dem Brechungsindexprofil angegebenen Formel aus dem Nahfeld errechnet werden, wobei für die Berechnung entsprechend das Nahfeld einzusetzen ist, das sich aus dem vorgegebenen Verlauf des Fernfelds entlang der zweiten Achse ergibt.

In einer bevorzugten Weiterbildung wird das weitere Brechungsindexprofil mittels Ausnehmungen in dem Bauelement, insbesondere in dem Halbleiterkörper, gebildet. Hierbei können die Ausnehmungen durch Entfernen von Material des Halbleiterkörpers mit der Halbleiterschichtenfolge, beispielsweise mechanisch und/oder chemisch, etwa mittels nasschemischen oder trockenchemischen Ätzens, ausgebildet werden.

Das strahlungsemittierende Bauelement mit einem zur Erzeugung von Strahlung vorgesehenen aktiven Bereich weist eine Hauptabstrahlungsrichtung auf, wobei der aktive Bereich zwischen den Feldformungsschichten angeordnet ist und mittels der Feldformungsschichten senkrecht zu der Hauptabstrahlungsrichtung ein Brechungsindexprofil gebildet ist. Das Brechungsindexprofil weist beidseits des aktiven Bereichs jeweils einen sprunghaften Übergang auf, an dem jeweils der Brechungsindex vom aktiven Bereich aus gesehen zunimmt.

Ein derartiges Bauelement kann eine Abstrahlcharakteristik mit einem vergleichsweise homogenen Fernfeld aufweisen.

In einer bevorzugten Weiterbildung der weiteren Ausführungsform ist das Brechungsindexprofil derart ausgeführt, dass aufgrund des Brechungsindexprofils eine Abstrahlcharakteristik der im Betrieb des Bauelements erzeugten Strahlung im Fernfeld in einem vorgegebenen Abstand zum aktiven Bereich eine höhere Homogenität aufweist als eine Gauß-förmige Abstrahlcharakteristik.

Aufgrund des beschriebenen Brechungsindexprofils bewirken die Feldformungsschichten ein Nahfeld, aus dem ein gegenüber einem Gauß'schen Fernfeld homogenisiertes Fernfeld resultiert. Die Homogenität der von einem derartigen Bauelement abgestrahlten Strahlung kann also höher sein als bei einem herkömmlichen Halbleiterlaser mit einem Gaußartigen Fernfeld.

Unter einem homogenen Fernfeld wird insbesondere ein Fernfeld verstanden, das in einem bestimmten Winkelbereich eine möglichst konstante Intensitätsverteilung aufweist und weiterhin einen vorgegebenen Schwellwert nicht unterschreitet.

Als Maß für die Homogenität des Fernfelds kann insbesondere die Fläche eines Rechtecks mit maximaler Fläche, das sich unter einer Kurve des Intensitätsverlaufs des Fernfelds erstreckt, herangezogen werden. Das Fernfeld ist hierbei die Intensität der vom strahlungsemittierenden Bauelement abgestrahlten Strahlung als Funktion des Winkels $\theta$ zur Hauptabstrahlungsrichtung. Bei einem Fernfeld mit Gauß'schem Verlauf beträgt die maximale Rechteckfläche 48,4 %.

Ein strahlungsemittierendes Bauelement, bei dem das Fernfeld also in einem vorgegebenen Abstand eine höhere Homogenität aufweist als eine Gauß-förmige Abstrahlcharakteristik, ist für das optische Pumpen von Lasern, für die Beleuchtung oder für die Abbildung auf optische Systeme besonders geeignet.

Unter einem sprunghaften Übergang wird insbesondere ein Bereich verstanden, in dem sich der Brechungsindex verglichen mit den an diesen sprunghaften Übergang angrenzenden Bereichen schnell ändert.

In einer bevorzugten Ausgestaltung füllt ein Rechteck mit maximaler Fläche, das sich unter einer Kurve des Intensitätsverlaufs des Fernfelds erstreckt, mindestens 50 %, besonders bevorzugt mindestens 60 %, am meisten bevorzugt mindestens 65 %, der Gesamtfläche unter der Kurve des Intensitätsverlaufs des Fernfelds aus. Je größer diese Fläche ist, desto größer kann der Anteil der vom Bauelement abgestrahlten nutzbaren Strahlung sein.

Der Intensitätsverlauf ist hierbei der Verlauf des Fernfelds entlang einer parallel zu dem Brechungsindexprofil verlaufenden Richtung.

Die Feldformungsschichten weisen jeweils einen Teilbereich auf, in dem der Brechungsindex mit zunehmendem Abstand vom aktiven Bereich kontinuierlich abnimmt. Weiterhin weisen die Feldformungsschichten jeweils einen weiteren Teilbereich auf, in dem der Brechungsindex ebenfalls mit zunehmendem Abstand von dem aktiven Bereich kontinuierlich abnimmt. Hierbei sind der Teilbereich und der weitere Teilbereich auf derselben Seite des aktiven Bereichs angeordnet.

Der sprunghafte Übergang ist zwischen dem ersten Teilbereich und dem zweiten Teilbereich angeordnet. Vom aktiven Bereich aus gesehen nimmt also das Brechungsindexprofil auf beiden Seiten des jeweiligen sprunghaften Übergangs kontinuierlich ab.

Eine Abstrahlcharakteristik mit besonders hoher Homogenität ist so vereinfacht erzielbar.

Im Bereich des sprunghaften Übergangs weist das Brechungsindexprofil vorzugsweise betragsmäßig eine größere Steigung auf als in den an den sprunghaften Übergang angrenzenden Teilbereichen. Beispielsweise kann das Brechungsindexprofil, insbesondere im Bereich der Feldformungsschichten, sägezahnartig ausgeführt sein.

Das Bauelement weist einen Halbleiterkörper mit einer Halbleiterschichtenfolge auf. Der aktive Bereich ist in dem

Halbleiterkörper ausgebildet. Weiterhin sind auch die Feldformungsschichten zumindest teilweise in dem Halbleiterkörper ausgebildet.

Das Brechungsindexprofil ist zumindest teilweise in dem Halbleiterkörper ausgebildet und verläuft senkrecht zu einer Haupterstreckungsrichtung der Halbleiterschichten des Halbleiterkörpers. Das Brechungsindexprofil verläuft also entlang einer Abscheiderichtung der Halbleiterschichten des Halbleiterkörpers. Die Halbleiterschichten des Halbleiterkörpers sind vorzugsweise epitaktisch, etwa mittels MOVPE oder MBE, hergestellt.

In einer weiteren bevorzugten Weiterbildung enthalten die Feldformungsschichten jeweils ein Verbindungshalbleitermaterial. Weiterhin bevorzugt ist das Brechungsindexprofil mittels einer Variation der Zusammensetzung des Verbindungshalbleitermaterials eingestellt. Anhand der Abhängigkeit des Brechungsindizes von der Materialzusammensetzung kann also aus dem ermittelten Brechungsindexprofil die hierfür erforderliche Materialkomposition bestimmt werden.

In einer bevorzugten Ausgestaltung weist das strahlungsemittierende Bauelement senkrecht zur Hauptabstrahlungsrichtung und senkrecht zu dem Brechungsindexprofil ein weiteres Brechungsindexprofil auf. Mittels dieses weiteren Brechungsindexprofils kann eine gezielte Feldformung des Nahfelds, insbesondere innerhalb des Halbleiterkörpers, erzielt werden. Auf diese Weise kann das resultierende Fernfeld der abgestrahlten Strahlung bezüglich zweier schräg oder senkrecht zueinander stehenden Achsen eingestellt und somit gemäß dem vorgegebenen Fernfeld geformt werden.

In einer bevorzugten Ausgestaltung ist das weitere Brechungsindexprofil mittels Ausnehmungen gebildet. Die Ausnehmungen erstrecken sich vorzugsweise in den Halbleiterkörper, insbesondere entlang des weiteren Brechungsindexprofils, hinein.

Mittels der Ausnehmungen kann für die entlang der Hauptabstrahlungsrichtung oszillierende Strahlung der entlang dieser Richtung gemittelte Brechungsindex eingestellt werden.

In einer bevorzugten Weiterbildung sind die Ausnehmungen zumindest teilweise mit einem Füllmaterial befüllt. Das Füllmaterial weist weiterhin bevorzugt einen kleineren Brechungsindex auf als das Material, in dem die Ausnehmungen ausgebildet sind. Insbesondere kann das Füllmaterial einen kleineren Brechungsindex aufweisen als das an die Ausnehmungen angrenzende Halbleitermaterial. Im Vergleich zum Brechungsindex des Halbleitermaterials kann so der gemittelte Brechungsindex mittels der Ausnehmungen verringert werden.

Von außen auf den Halbleiterkörper gesehen können sich die Ausnehmungen mit zunehmender Tiefe verjüngen. Ein, insbesondere kontinuierlich, abnehmender Verlauf des gemittelten Brechungsindizes zum Rand des Halbleiterkörpers hin kann so erzielt werden.

In einer weiteren bevorzugten Ausgestaltung weist das Bauelement einen weiteren aktiven Bereich auf, der zur Erzeugung von Strahlung vorgesehen ist. Die insgesamt aus dem Bauelement austretende Strahlungsleistung kann so gesteigert werden.

Zwischen dem aktiven Bereich und dem weiteren aktiven Bereich kann ein Tunnelbereich ausgebildet sein. Mittels dieses Tunnelbereichs können der aktive Bereich und der weitere aktive Bereich elektrisch in Serie miteinander verbunden sein. Der Tunnelbereich ist vorzugsweise mittels zweier Halbleiterschichten gebildet, die jeweils mit zueinander entgegengesetztem Vorzeichen hochdotiert ausgeführt sind. Bevorzugt beträgt die Dotierkonzentration jeweils mindestens $10^{18}$ cm$^{-3}$, besonders bevorzugt mindestens $10^{19}$ cm$^{-3}$.

In einer Ausgestaltungsvariante weisen die im aktiven Bereich erzeugte Strahlung und die im weiteren aktiven Bereich erzeugte Strahlung eine gemeinsame transversale optische Mode auf. Diese Strahlungsanteile können also kohärent gekoppelt sein.

Weiterhin bevorzugt ist der Tunnelbereich in einem Knoten der transversalen optischen Mode angeordnet. Eine Absorption der optischen Strahlungsleistung im Tunnelbereich kann so vermieden oder zumindest vermindert werden.

Der weitere aktive Bereich kann in den Feldformungsschichten ausgebildet sein. Insbesondere kann zwischen dem aktiven Bereich und dem weiteren aktiven Bereich einer der sprunghaften Übergänge angeordnet sein.

In einer alternativen Ausgestaltungsvariante sind beidseits des weiteren aktiven Bereichs weitere Feldformungsschichten angeordnet, wobei das Brechungsindexprofil beidseits des weiteren aktiven Bereichs jeweils einen weiteren sprunghaften Übergang aufweist, an dem jeweils der Brechungsindex vom weiteren aktiven Bereich aus gesehen zunimmt.

In diesem Fall sind der aktive Bereich und der weitere aktive Bereich vorzugsweise übereinander angeordnet, wobei den aktiven Bereichen jeweils eigene Feldformungsschichten zugeordnet sind.

Hierbei können die weiteren Feldformungsschichten zumindest eines der im Zusammenhang mit den Feldformungsschichten beschriebenen Merkmale aufweisen. Weiterhin können die Feldformungsschichten, die dem aktiven Bereich zugeordnet sind und die weiteren Feldformungsschichten, die dem weiteren aktiven Bereich zugeordnet sind, gleichartig ausgebildet sein. Davon abweichend können die Feldformungsschichten und die weiteren Feldformungsschichten voneinander verschieden und insbesondere an den aktiven Bereich beziehungsweise den weiteren aktiven Bereich angepasst sein. Hierbei können der aktive Bereich und der weitere aktive Bereich auch für die Emission von Strahlung mit unterschiedlichen Wellenlängen vorgesehen sein.

Der aktive Bereich und/oder die Feldformungsschichten enthalten vorzugsweise ein Verbindungshalbleitermaterial, besonders bevorzugt ein III-V-Verbindungshalbleitermaterial, insbesondere aus der Materialkombination (AlInGa)(AsPNSb), also einer Kombination von zumindest einem der genannten Elemente aus der dritten Gruppe des Periodensystems mit zumindest einem der genannten Elemente aus der fünften Gruppe des Periodensystems. Das Material kann insbesondere aus der Gruppe bestehend aus $Al_xIn_yGa_{1-x-y}As$, $Al_xIn_yGa_{1-x-y}P$, $Al_xIn_yGa_{1-x-y}N$ und $Al_xIn_yGa_{1-x-y}Sb$, jeweils mit $0 \leq x \leq 1$, $0 \leq y \leq 1$ und $x + y \leq 1$, gewählt sein. Mit diesen Materialien kann Strahlung vom ultravioletten über den sichtbaren bis in den infraroten Spektralbereich auf effiziente Weise erzeugt werden.

Vorzugsweise ist das strahlungsemittierende Bauelement als ein kantenemittierendes Halbleiterlaserbauelement ausgeführt. Bei einem kantenemittierenden Halbleiterlaserbauelement verläuft die Hauptabstrahlungsrichtung parallel zu der Haupterstreckungsebene der Halbleiterschichten des Halbleiterkörpers.

Auch eine Ausführung des strahlungsemittierenden Bauelements als ein oberflächenemittierendes Halbleiterlaserbauelement, etwa als VCSEL (vertical cavity surface emitting laser), als VECSEL (vertical external cavity surface emitting laser) oder als Scheibenlaser (disk laser), ist alternativ denkbar. Bei einem oberflächenemittierenden Halbleiterlaserbauelement läuft die Hauptabstrahlungsrichtung des Bauelements senkrecht zu der Haupterstreckungsebene der Halbleiterschichten des Halbleiterkörpers.

In einer bevorzugten Weiterbildung ist das strahlungsemittierende Bauelement als Pumplaser ausgeführt.

Das weiter oben beschriebene Verfahren ist zur Herstellung des strahlungsemittierenden Bauelements besonders geeignet. Im Zusammenhang mit dem strahlungsemittierenden Bauelement ausgeführte Merkmale können daher auch für das Verfahren herangezogen werden und umgekehrt.

Weitere Merkmale, vorteilhafte Ausgestaltungen und Zweckmäßigkeiten ergeben sich aus der folgenden Beschreibung der Ausführungsbeispiele in Verbindung mit den Figuren. Es zeigen:

die Figuren 1A bis 1E ein erstes Beispiel für ein Verfahren zur Herstellung eines strahlungsemittierenden Bauelements,

die Figuren 2A bis 2E ein zweites Beispiel für ein Verfahren zur Herstellung eines optoelektronischen Bauelements,

Figur 3 eine Intensitätsverteilung I für ein Gauß'sches Fernfeld als Funktion des Winkels θ zur Hauptabstrahlungsrichtung,

die Figuren 4A bis 4C Ergebnisse von elektrooptischen Simulationen, wobei Figur 4A ein Brechungsindexprofil, Figur 4B eine zugehörige Intensitätsverteilung des Nahfelds und Figur 4C die Strahlungsleistung P als Funktion des injizierten Stroms j zeigt, für das gemäß Figur 2E ausgeführte strahlungsemittierende Bauelement,

Figur 5 einen qualitativen Verlauf eines Brechungsindexprofils für ein zweites Ausführungsbeispiel eines strahlungsemittierenden Bauelements,

Figur 6 einen qualitativen Verlauf des Brechungsindexprofils für ein drittes Ausführungsbeispiel eines strahlungsemittierenden Bauelements, und

Figur 7 ein viertes Ausführungsbeispiel für ein optoelektronisches Bauelement in schematischer Aufsicht mit einem zugehörigen qualitativen Brechungsindexprofil.

Gleiche, gleichartige oder gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

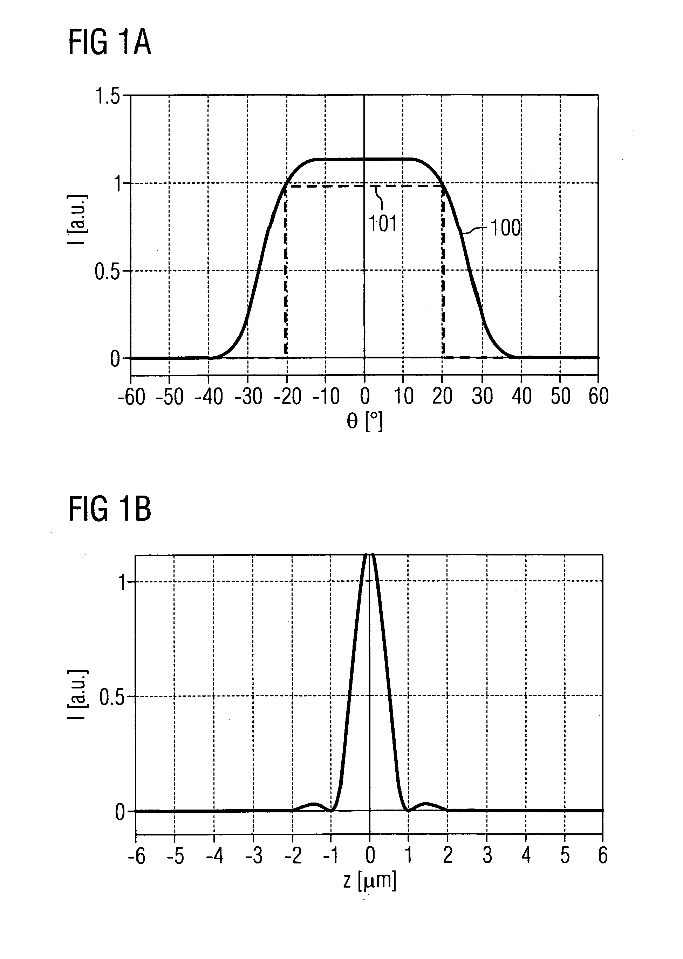

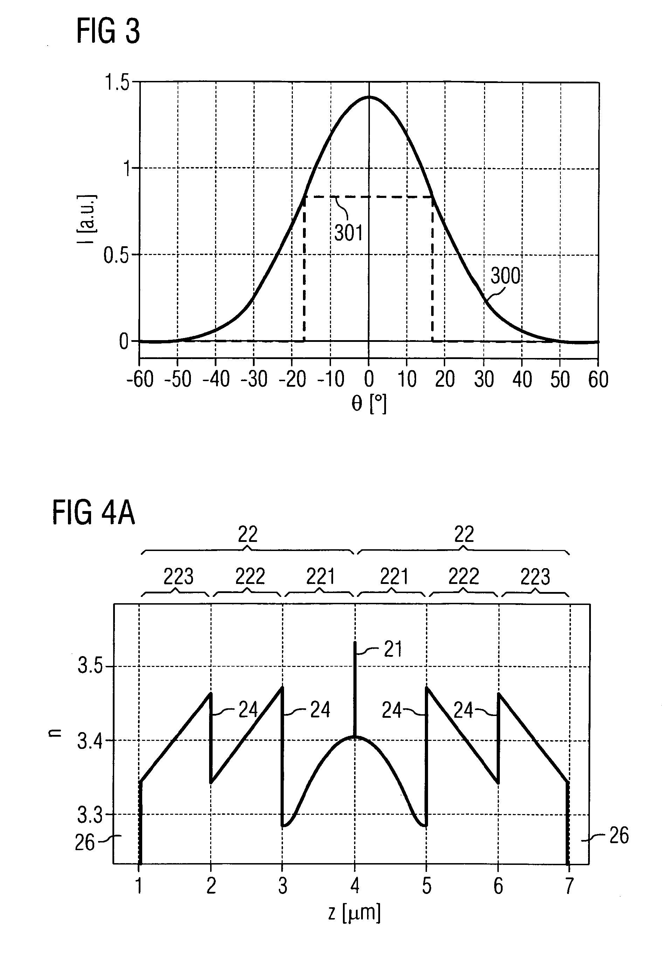

Figur 1A zeigt einen Verlauf der Intensität I eines dem strahlungsemittierenden Bauelements vorgegebenen Verlaufs des Fernfelds. Die Intensität I ist hierbei als Funktion des Winkels θ zur Hauptabstrahlungsrichtung des Bauelements dargestellt. Der Intensitätsverlauf zeigt in einem Winkel von etwa +/- 15° einen plateauartigen Verlauf, in dem sich die Intensität praktisch nicht verändert. Die gestrichelte Linie 101 bildet hierbei die Umrandung eines Rechtecks mit maximaler Fläche, das unterhalb des Intensitätsverlaufs 100 verläuft. Das Rechteck füllt hierbei etwa 68,8 % der unterhalb der Intensitätskurve 100 ausgebildeten Fläche. Im Vergleich hierzu ist in Figur 3 ein entsprechender Intensitätsverlauf 300 mit einem zugehörigen Rechteck maximaler Fläche 301 für den Fall eines Gauß'schen Strahlungsprofils gezeigt. In diesem Fall beträgt die Fläche des Rechtecks maximaler Fläche 301 etwa 48,4 % der von der Intensitätskurve 300 eingeschriebenen Fläche. Das in Figur 1A dargestellte Intensitätsprofil des Fernfelds weist somit eine erheblich höhere Homogenität auf als eine Gauß-förmige Intensitätsverteilung.

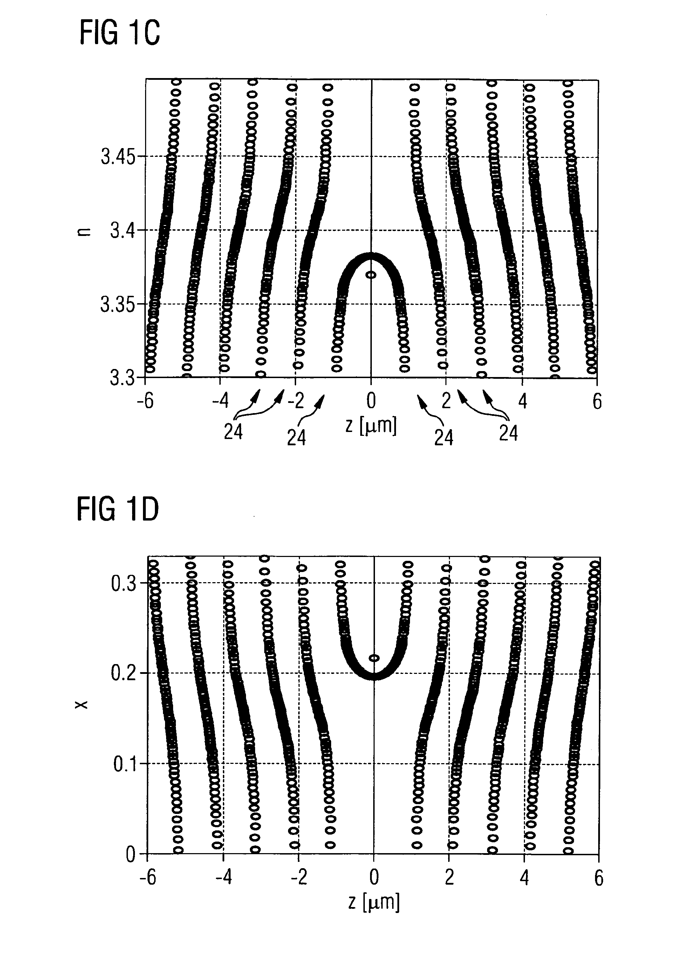

In Figur 1B ist das zugehörige Nahfeld dargestellt. Das Nahfeld ergibt sich hierbei durch eine räumliche Fourier-Transformation aus dem in Figur 1A dargestellten Fernfeld. Aus diesem Nahfeld kann, wie in Figur 1C dargestellt, nach der weiter oben angegebenen Beziehung ein Brechungsindexprofil ermittelt werden. Ausgehend von dem Nullpunkt der z-Achse weist der Brechungsindexverlauf eine Mehrzahl von Teilbereichen auf, in denen der Brechungsindex jeweils mit zunehmendem Abstand abnimmt. Zwischen diesen Teilbereichen ist jeweils ein sprunghafter Übergang 24 ausgebildet, in dem der Brechungsindex von einem kleineren Wert auf einen größeren Wert springt. Der dargestellte Brechungsindexverlauf kann in einen Verlauf der Materialzusammensetzung umgerechnet werden. Diese Umrechnung ist hierbei von dem jeweils für das Bauelement vorgesehenen Material abhängig.

In Figur 1D ist exemplarisch der Verlauf des Aluminiumgehalts x für eine Halbleiterschichtenfolge gezeigt, die auf $Al_xGa_{1-x}As$ basiert. Mit einem entsprechend der Figur 1D ausgebildeten Profil für den Aluminiumgehalt kann also das in Figur 1C dargestellte Brechungsindexprofil, zumindest in guter Näherung, umgesetzt werden.

Basierend auf dem so ermittelten Aufbau für das Bauelement kann das Bauelement ausgebildet werden.

Wie der Intensitätsverlauf des Nahfelds in Figur 1B zeigt, weist das Nahfeld praktisch ausschließlich in einem Bereich zwischen -2 und +2 μm um die Mittelachse (z=0) von 0 verschiedene Werte auf. Bei dem herzustellenden strahlungsemittierenden Bauelement muss daher das Brechungsindexprofil und somit der daraus errechnete Verlauf der Materialkomposition nur in diesem Bereich umgesetzt werden. Für größere Werte von z ist die Intensität des Nahfelds so gering, dass auf eine möglichst exakte Nachbildung des errechneten Brechungsindexprofils verzichtet werden kann.

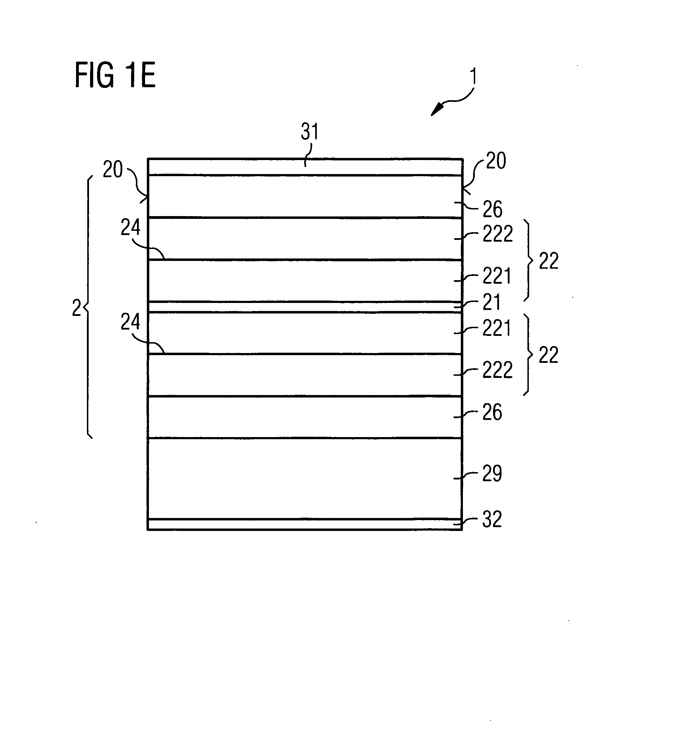

In Figur 1E ist ein derartiges strahlungsemittierendes Bauelement 1 schematisch in Schnittansicht dargestellt. Das strahlungsemittierende Bauelement weist einen Halbleiterkörper 2 mit einer Halbleiterschichtenfolge auf. Die Halbleiterschichtenfolge bildet den Halbleiterkörper und ist vorzugsweise epitaktisch, etwa mittels MOVPE oder MBE, hergestellt. Die Halbleiterschichtenfolge des Halbleiterkörpers 2 ist auf einem Träger 29 angeordnet. Der Träger 29 kann das Aufwachssubstrat sein, auf dem die Halbleiterschichtenfolge des Halbleiterkörpers abgeschieden wurde. Davon abweichend kann der Träger auch vom Aufwachssubstrat verschieden sein. In diesem Fall muss der Träger nicht notwendigerweise die hohen Anforderungen an ein Aufwachssubstrat, insbesondere hinsichtlich der kristallinen Reinheit, erfüllen, sondern kann vielmehr bezüglich anderer Eigenschaften, wie thermischer oder elektrischer Leitfähigkeit und/oder mechanischer Stabilität gewählt werden.

Der Halbleiterkörper weist einen aktiven Bereich 21 auf, der im Betrieb des Halbleiterkörpers zur Erzeugung von Strahlung vorgesehen ist. Auf beiden Seiten des aktiven Bereichs ist jeweils eine Kontaktschicht 31 beziehungsweise eine weitere Kontaktschicht 32 angeordnet. Die Kontaktschichten dienen vorzugsweise der externen elektrischen Kontaktierung des Halbleiterkörpers 2. Im Betrieb des strahlungsemittierenden Bauelements können Ladungsträger über die Kontaktschichten 31 und 32 von zwei verschiedenen Seiten in den aktiven Bereich injiziert werden und dort unter Emission von Strahlung rekombinieren.

Auf beiden Seiten des aktiven Bereichs ist jeweils eine Feldformungsschicht 22 angeordnet. Auf der dem aktiven Bereich 21 abgewandten Seite der Feldformungsschichten 22 ist jeweils eine Mantelschicht 26 angeordnet. Die Mantelschichten weisen vorzugsweise jeweils einen Brechungsindex auf, der kleiner ist als der Brechungsindex der Feldformungsschichten 22. Im Halbleiterkörper oszillierende Strahlung kann so in vertikaler Richtung zu einem großen Anteil auf den Bereich zwischen den Mantelschichten 26 beschränkt werden.

Weiterhin weist der Halbleiterkörper 2 eine Seitenfläche 20 auf, die den Halbleiterkörper in lateraler Richtung, also entlang einer Haupterstreckungsrichtung der Halbleiterschichten des Halbleiterkörpers 2, begrenzt. Zumindest eine der Seitenflächen 20 des Halbleiterkörpers 2 ist zur Auskopplung der im Betrieb des strahlungsemittierenden Bauelements 1 erzeugten kohärenten Strahlung vorgesehen. Das strahlungsemittierende Bauelement ist also als ein kantenemittierendes Halbleiterlaserbauelement ausgeführt.

Die Seitenflächen 20 können hierbei beispielsweise chemisch, etwa mittels nasschemischem oder trockenchemischem Ätzens, oder mechanisch, etwa mittels Spaltens oder Brechens, hergestellt werden.

Für die Herstellung des strahlungsemittierenden Bauelements sind prinzipiell alle Halbleitermaterialien geeignet, die zur Erzeugung von Strahlung geeignet sind.

Bevorzugt enthält das strahlungsemittierende Bauelement 1, insbesondere der aktive Bereich 21 und/oder die Feldformungsschichten 22, ein III-V-Verbindungshalbleitermaterial, insbesondere aus einer Materialkombination (AlInGa)(AsPNSb), wobei das Verbindungshalbleitermaterial zumindest eines der genannten Elemente aus der dritten Gruppe und zumindest eines der genannten Elemente aus der fünften Gruppe des Periodensystems enthält.

III-V-Verbindungshalbleitermaterialien sind zur Strahlungserzeugung im ultravioletten ($Al_xIn_yGa_{1-x-y}N$) über den sichtbaren ($Al_xIn_yGa_{1-x-y}N$, insbesondere für blaue bis grüne Strahlung, oder $Al_xIn_yGa_{1-x-y}P$, insbesondere für gelbe bis rote Strahlung) bis in den infraroten ($Al_xIn_yGa_{1-x-y}As$, $Al_xIn_yGa_{1-x-y}Sb$) Spektralbereich besonders geeignet. Hierbei gilt jeweils $0 \leq x \leq 1$, $0 \leq y \leq 1$ und $x + y \leq 1$, insbesondere mit $x \neq 1$, $y \neq 1$, $x \neq 0$ und/oder $y \neq 0$. Mit III-V-Halbleitermaterialien, insbesondere aus den genannten Materialsystemen, können weiterhin bei der Strahlungserzeugung hohe interne Quanteneffizienzen erzielt werden.

Nachfolgend wird exemplarisch ein Schichtaufbau für ein Bauelement beschrieben, das auf dem Materialsystem $Al_xIn_yGa_{1-x-y}As$ basiert. Der aktive Bereich 21 ist mittels einer Quantenschicht gebildet, die eine Dicke von 6,5 nm aufweist und auf $In_{0,13}Ga_{0,87}As$ basiert. Davon abweichend kann der aktive Bereich auch eine Quantenstruktur mit mehr als einer Quantenschicht, etwa zwei Quantenschichten oder mehr, aufweisen. Insbesondere durch Variation der Schichtdicke und/oder des Indiumgehalts kann die Peak-Wellenlänge der im aktiven Bereich erzeugten Strahlung eingestellt werden.

Die Bezeichnung Quantenstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantenstruktur keine Angabe über die Dimensionalität der Quantisierung. Sie umfasst somit unter anderem Quantentröge, Quantendrähte und Quantenpunkte und jede Kombination dieser Strukturen.

Zweckmäßigerweise sind die Halbleiterschichten auf der einen Seite des aktiven Bereichs 21 n-leitend dotiert und die auf der anderen Seite des aktiven Bereichs zumindest teilweise p-leitend dotiert. Beispielsweise können die zwischen dem aktiven Bereich 21 und dem Träger 29 angeordneten Halbleiterschichten n-leitend dotiert sein.

Der aktive Bereich ist zwischen zwei Feldformungsschichten 22 angeordnet, wobei die Feldformungsschichten 22 jeweils einen Teilbereich 221 und einen weiteren Teilbereich 222 aufweisen. Der weitere Teilbereich 222 befindet sich hierbei in einem größeren Abstand zum aktiven Bereich 21 als der Teilbereich 221.

Die Teilbereiche 221 enthalten jeweils das Material $Al_xGa_{1-x}As$, wobei der Aluminiumgehalt x vom aktiven Bereich 21 aus mit zunehmendem Abstand von einem Wert von 0,20 auf einen Wert von 0,35 zunimmt. Vorzugsweise erfolgt die Zunahme kontinuierlich. Entsprechend nimmt der Brechungsindex jeweils ab.

Die weiteren Teilbereiche 222 enthalten jeweils $Al_xGa_{1-x}As$ mit einem Aluminiumgehalt x, der mit zunehmendem Abstand vom aktiven Bereich 21 von einem Wert von 0,10 auf einen Wert von 0,35 zunimmt. Die Zunahme erfolgt vorzugsweise kontinuierlich, insbesondere linear oder zumindest weitgehend linear. An dem sprunghaften Übergang 24, der zwischen dem Teilbereich 221 und dem weiteren Teilbereich 222 entsteht, nimmt der Aluminiumgehalt von 35 % sprunghaft auf 20 % ab. Vom aktiven Bereich 21 aus gesehen nimmt der Aluminiumgehalt x auf beiden Seiten des sprunghaften Übergangs 24 also zu. Entsprechend nimmt der Brechungsindex jeweils ab.

Die Teilbereiche 221, 222 der Feldformungsschichten 22 weisen jeweils eine Dicke von 940 nm auf.

Die Mantelschichten 26, die jeweils auf der dem aktiven Bereich 21 abgewandten Seite der Feldformungsschichten 22 angeordnet sind, weisen jeweils eine Dicke von 1000 nm auf und enthalten das Material $Al_{0,50}Ga_{0,50}As$. Der Aluminiumgehalt der Mantelschichten 26 ist also höher als der Aluminiumgehalt der Feldformungsschichten. Folglich ist der Brechungsindex der Mantelschichten kleiner als der Brechungsindex der Feldformungsschichten 22, sodass eine transversale Mode der im aktiven Bereich 21 erzeugten Strahlung zumindest weitgehend auf den Bereich zwischen den Mantelschichten begrenzt werden kann.

Der Träger 29 ist zweckmäßigerweise elektrisch leitend. Bei einem Träger, der auf Halbleitermaterial, etwa GaAs, Ge, Si oder GaP basiert, ist dieser zweckmäßigerweise gleichartig wie die zwischen dem Träger 29 und dem aktiven Bereich 21 angeordneten Halbleiterschichten 22, 26 dotiert.

Davon abweichend kann der Träger auch elektrisch isolierend ausgebildet sein. In diesem Fall ist die weitere Kontaktschicht 32 zweckmäßigerweise auf der dem aktiven Bereich 21 zugewandten Seite des Trägers 29 angeordnet. In diesem ersten Beispiel wird also das Brechungsindexprofil dadurch erzielt, dass die Materialzusammensetzung der Halbleiterschichtenfolge des Halbleiterkörpers 2 entlang der Abscheiderichtung, also senkrecht zur Haupterstreckungsrichtung der Halbleiterschichten des Halbleiterkörpers 2, geeignet variiert wird.

Für die Feldformungsschichten 22 sind hierbei Verbindungshalbleitermaterialien besonders geeignet, bei denen der Brechungsindex mittels einer Variation der Zusammensetzung des Verbindungshalbleitermaterials einstellbar ist.

Auf diese Weise kann ein strahlungsemittierendes Bauelement hergestellt werden, deren abgestrahlte Strahlung im Fernfeld in einem vorgegebenen Abstand eine höhere Homogenität aufweist als ein Bauelement, das Strahlung mit einer Gaußförmigen Abstrahlcharakteristik emittiert.

Ein Rechteck mit maximaler Fläche, das sich unter der Kurve des Intensitätsverlaufs des Fernfelds erstreckt, füllt vorzugsweise mindestens 50 %, besonders bevorzugt mindestens 60 %, am meisten bevorzugt mindestens 65 %, der Gesamtfläche unter der Kurve des Intensitätsverlaufs des Fernfelds.

Ein derartiges strahlungsemittierendes Bauelement ist als Pumplaser besonders geeignet.

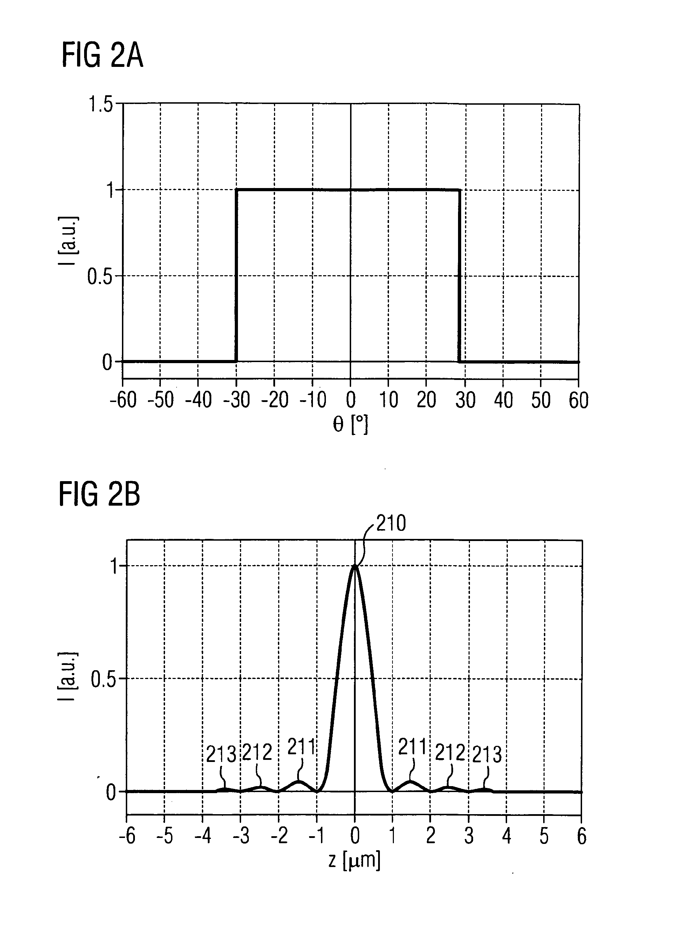

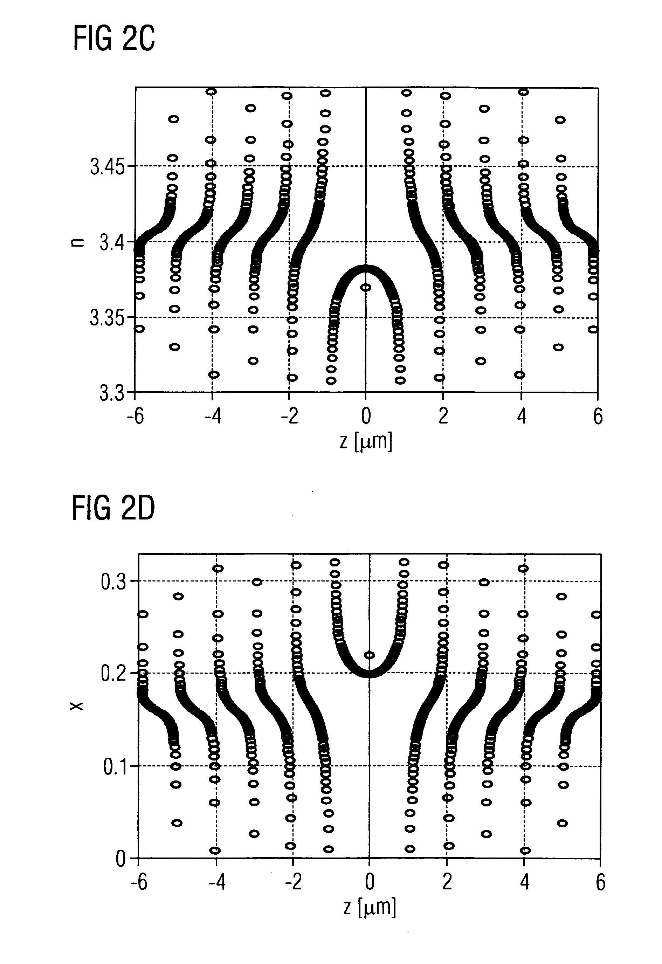

Ein weiteres Beispiel für ein Verfahren zur Herstellung eines strahlungsemittierenden Bauelements ist in den Figuren 2A bis 2E schematisch dargestellt. Dieses zweite Beispiel entspricht im Wesentlichen dem ersten Beispiel. Im Unterschied hierzu ist die vorgegebene Abstrahlcharakteristik im Fernfeld ein Rechteckprofil, es handelt sich also um den Verlauf eines Fernfelds mit idealer Homogenität, bei dem ein Rechteck unter der Kurve die gesamte Fläche ausfüllt.

Das der Figur 2A zugrunde liegende Nahfeld, das mittels räumlicher Fourier-Transformation aus dem in Figur 2A dargestellten Verlauf errechnet ist, ist in Figur 2B dargestellt. Der Intensitätsverlauf zeigt neben einem Hauptmaximum 210 eine Mehrzahl von Nebenmaxima 211, 212, 213. Im Unterschied zum in Figur 1B dargestellten Intensitätsverlauf zeigt dieser also auch bei größeren Abständen, etwa für z= 3,5 $\mu$m von 0 verschiedene Werte.

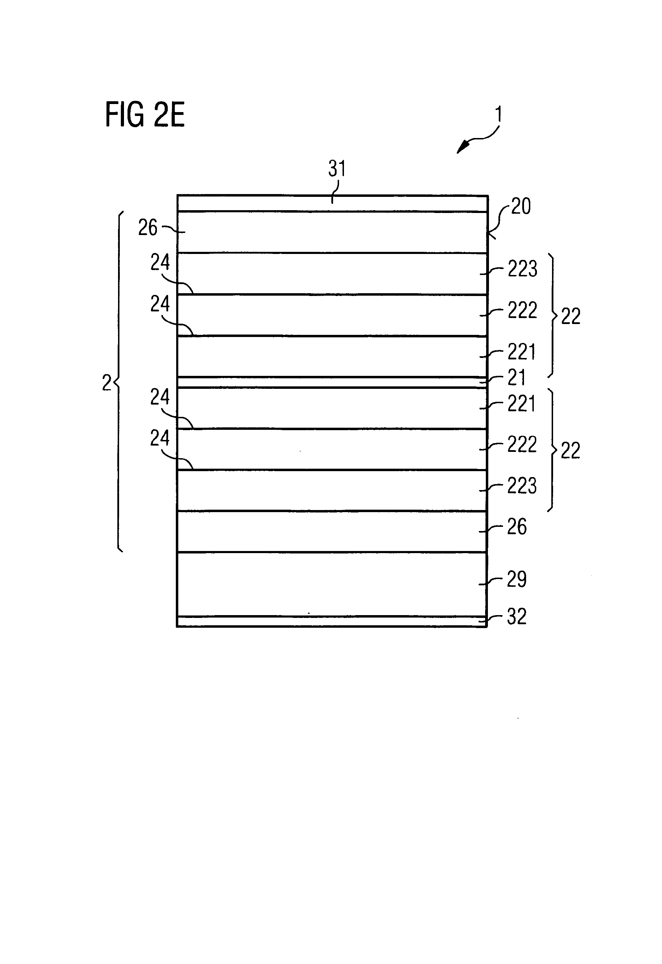

Die aus dem in Figur 2B dargestellten Nahfeld ermittelten Werte für das Brechungsindexprofil n beziehungsweise für den Aluminiumgehalt x können wie im Zusammenhang mit den Figuren 1C und 1D beschrieben errechnet werden und sind in den Figuren 2C beziehungsweise 2D dargestellt. Ein strahlungsemittierendes Bauelement 1 mit einem Halbleiterkörper 2, dessen Schichtaufbau derart ausgeführt ist, dass die im aktiven Bereich 21 erzeugte Strahlung in einem vorgegebenen Abstand ein Fernfeld aufweist, das dem in Figur 2A dargestellten idealen Profil nahe kommt, ist in Figur 2E in Schnittansicht schematisch gezeigt.

Der Aufbau des strahlungsemittierenden Bauelements 1 entspricht im Wesentlichen dem im Zusammenhang mit Figur 1E beschriebenen strahlungsemittierenden Bauelement. Im Unterschied hierzu weisen die Feldformungsschichten 22 jeweils einen zusätzlichen Teilbereich 223 auf, der auf der dem aktiven Bereich 21 abgewandten Seite des weiteren Teilbereichs 222 ausgebildet ist.

Die Feldformungsschichten 22 weisen jeweils zwei sprunghafte Übergänge 24 auf, die zwischen dem Teilbereich 221 und dem weiteren Teilbereich 222 beziehungsweise zwischen dem weiteren Teilbereich 222 und dem zusätzlichen Teilbereich 223 ausgebildet sind. Vorzugsweise nimmt der Aluminium-Gehalt in dem zusätzlichen Teilbereich 223 der Feldformungsschicht 22 mit zunehmendem Abstand zum aktiven Bereich, besonders bevorzugt kontinuierlich, zu. Der Brechungsindex der weiteren Feldformungsschicht nimmt demnach mit zunehmendem Abstand zum aktiven Bereich ab.

Mittels des beschriebenen Brechungsindexprofils, das auf beiden Seiten des aktiven Bereichs jeweils zwei sprunghafte Übergänge aufweist, an denen der Brechungsindex vom aktiven Bereich aus gesehen jeweils sprunghaft ansteigt, kann sich zwischen den Mantelschichten 26 in den Feldformungsschichten 22 eine Intensitätsverteilung des Nahfelds derart ausbilden, dass die vom aktiven Bereich 21 abgestrahlte Strahlung im Fernfeld in einem vorgegebenen Abstand der Abstrahlcharakteristik mit idealer Homogenität nahe kommt.

In den Figuren 4A bis 4C sind Ergebnisse von elektrooptischen Simulationen für ein strahlungsemittierendes Bauelement gezeigt, das gemäß dem im Zusammenhang mit Figur 2E beschriebenen Ausführungsbeispiel ausgeführt ist.

Die z-Richtung entspricht hierbei jeweils der Abscheiderichtung der Halbleiterschichten des Halbleiterkörpers 2, wobei der Nullpunkt in dieser Darstellung die dem aktiven Bereich zugewandte Grenzfläche des Trägers 29 ist. Das in Figur 4A dargestellte Brechungsindexprofil weist auf beiden Seiten des aktiven Bereichs 21 jeweils zwei sprunghafte Übergänge 24 auf, an denen der Brechungsindex vom aktiven Bereich aus gesehen sprunghaft ansteigt. Auf beiden Seiten des sprunghaften Übergangs 24 nimmt der Brechungsindex jeweils mit zunehmendem Abstand vom aktiven Bereich ab.

Das Brechungsindexprofil ist symmetrisch zum aktiven Bereich 21 ausgebildet. Eine symmetrische Abstrahlung der im aktiven Bereich erzeugten Strahlung wird dadurch vereinfacht.

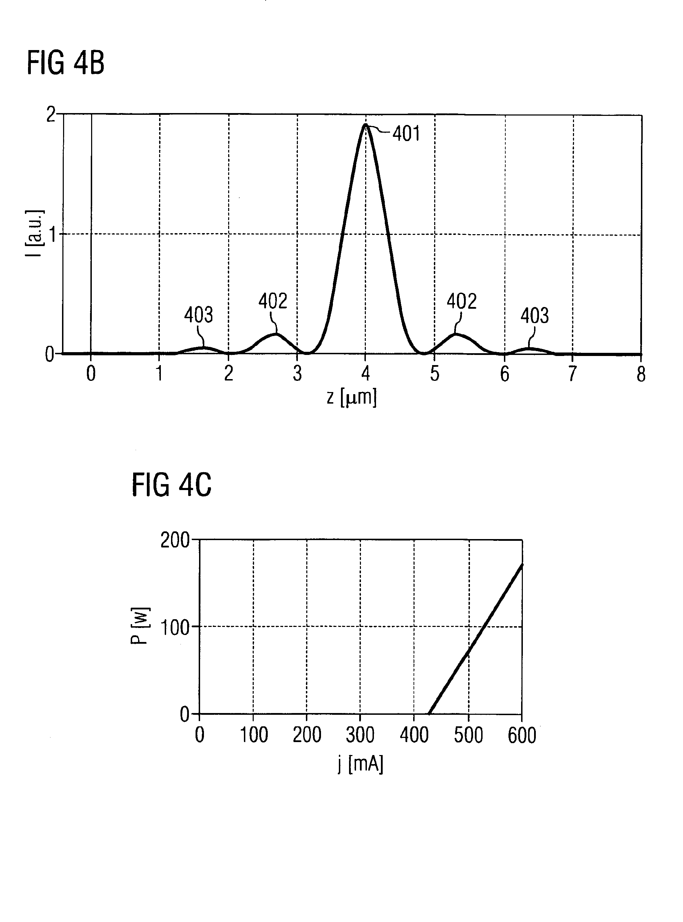

Das aus dem in Figur 4A dargestellten Brechungsindexprofil resultierende Nahfeld ist in Figur 4B als Intensitätsverteilung entlang der Abscheiderichtung z dargestellt. Die Intensitätsverteilung weist neben dem Hauptmaximum 401 auf beiden Seiten jeweils die Intensitätsnebenmaxima 402 und 403 auf und unterscheidet sich somit deutlich von einem Bauelement mit Gauß'scher Abstrahlcharakteristik im Fernfeld. Bei einem Gauß'schen Fernfeld weist auch das zugehörige Nahfeld eine Gauß'sche Form auf und zeigt somit keine Nebenmaxima.

Wie ein Vergleich der Figur 4A mit der Figur 4B zeigt, bildet sich das Nebenmaximum 402 im weiteren Teilbereich 222 der Feldformungsschicht 22 und das Nebenmaximum 403 im zusätzlichen Teilbereich 223 der Feldformungsschicht 22 aus. Der zum Hauptmaximum 401 gehörige Anteil der Intensität ist entlang der z-Richtung auf den aktiven Bereich 21 und die Teilbereiche 221 der Feldformungsschichten 22 beschränkt. Aufgrund des beschriebenen Brechungsindexprofils sind die Feldformungsschichten 22 also in der Lage, das Nahfeld der im aktiven Bereich 21 erzeugten Strahlung derart auszubilden, dass das resultierende Fernfeld in einem vorgegebenen Abstand eine höhere Homogenität aufweist als eine Gauß'sche Abstrahlcharakteristik.

Das in Figur 4B dargestellte Nahfeld weist einen Überlapp (confinement) mit dem aktiven Bereich von 0,8 % auf. Optische Moden höherer Ordnung haben einen bedeutend niedrigeren Confinement-Faktor und schwingen gemäß den Simulationen nicht an.

Der simulierte Verlauf der Ausgangsleistung P als Funktion des injizierten Stroms j ist in Figur 4C dargestellt. Das Bauelement weist eine Laserschwelle von knapp über 400 mA auf. Die Steilheit beträgt etwa 1 W/A. Die dargestellten Simulationen zeigen, dass mit dem beschriebenen Verfahren ein Bauelement hergestellt werden kann, das ein homogenisiertes Fernfeld bei gleichzeitig guten elektrooptischen Eigenschaften aufweist.

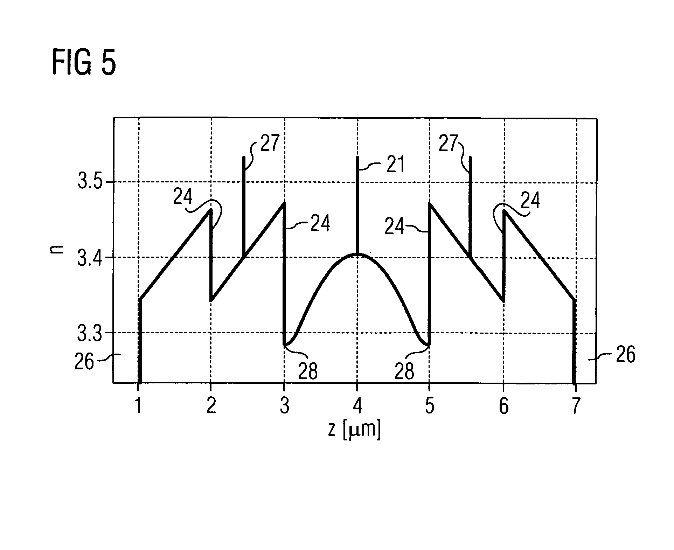

Ein qualitativer Verlauf für ein Brechungsindexprofil eines dritten Ausführungsbeispiels für ein strahlungsemittierendes Bauelement ist in Figur 5 dargestellt.

Dieses dritte Ausführungsbeispiel entspricht im Wesentlichen dem im Zusammenhang mit Figur 4A beschriebenen zweiten Ausführungsbeispiel. Im Unterschied hierzu weist das strahlungsemittierende Bauelement zusätzlich zum aktiven Bereich 21 auf beiden Seiten des aktiven Bereichs jeweils einen weiteren aktiven Bereich 27 auf. Die weiteren aktiven Bereiche 27 sind jeweils in den Feldformungsschichten 22 angeordnet.

Zwischen dem aktiven Bereich 21 und den weiteren aktiven Bereichen 27 ist jeweils ein Tunnelbereich 28 ausgebildet. Die Tunnelbereiche 28 sind dafür vorgesehen, die weiteren aktiven Bereiche 27 und den aktiven Bereich zueinander in Serie zu verschalten. Vorzugsweise weisen die Tunnelbereiche jeweils eine hochdotierte n-leitende Halbleiterschicht und eine hochdotierte p-leitende Halbleiterschicht auf. Die Dotierkonzentrationen betragen vorzugsweise jeweils mindestens $10^{18}$ cm$^{-3}$, besonders bevorzugt mindestens $10^{19}$ cm$^{-3}$.

Die Tunnelbereiche 28 sind vorzugsweise im Bereich eines sprunghaften Übergangs 24 des Brechungsindexprofils angeordnet. In diesen Bereichen ist die Intensität des Nahfelds, wie die Figuren 4A und 4B zeigen, vergleichsweise gering. Eine Absorption der Strahlungsintensität des Nahfelds in den Tunnelbereichen 28 kann so vermieden oder zumindest stark vermindert werden.

Der aktive Bereich 21 und die weiteren aktiven Bereiche 27 können kohärent gekoppelt sein. Das heißt, die im aktiven Bereich erzeugte Strahlung und die in den weiteren aktiven Bereichen erzeugte Strahlung weisen eine gemeinsame transversale optische Mode auf. In einem Knoten dieser optischen Mode, der sich wie oben beschrieben im Bereich des sprunghaften Übergangs 24 ausbilden kann, sind vorzugsweise jeweils die Tunnelbereiche 28 angeordnet.

Durch die zusätzlichen aktiven Bereiche 27 kann die insgesamt aus dem Bauelement austretende Strahlungsleistung gesteigert werden.

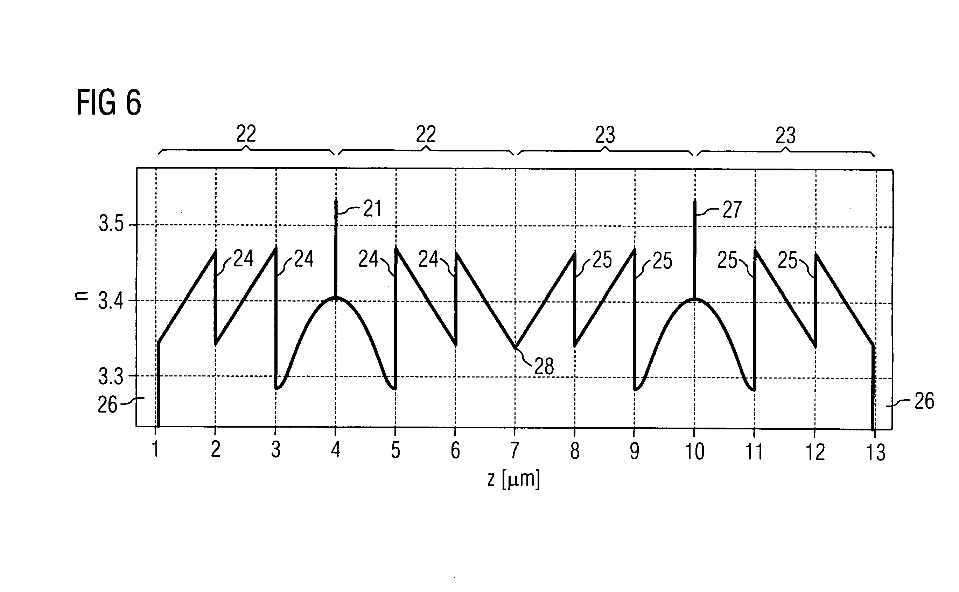

Ein Brechungsindexprofil für ein viertes Ausführungsbeispiel eines strahlungsemittierenden Bauelements ist in Figur 6 dargestellt. Dieses vierte Ausführungsbeispiel entspricht im Wesentlichen dem im Zusammenhang mit Figur 4A beschriebenen zweiten Ausführungsbeispiel. Im Unterschied hierzu weist der Halbleiterkörper des strahlungsemittierenden Bauelements einen weiteren aktiven Bereich 27 auf. Der aktive Bereich 21 und der weitere aktive Bereich sind übereinander angeordnet, wobei der weitere aktive Bereich zwischen zwei weiteren Feldformungsschichten 23 angeordnet ist. Der aktive Bereich 21 und der weitere aktive Bereich 27 sind in diesem Ausführungsbeispiel gleichartig ausgeführt.

Weiterhin sind die Feldformungsschichten 22 und die Feldformungsschichten 23 gleichartig ausgeführt. Das Brechungsindexprofil weist also beidseits des weiteren aktiven Bereichs 27 jeweils zwei weitere sprunghafte Übergänge 25 auf, an denen jeweils der Brechungsindex vom weiteren aktiven Bereich aus gesehen zunimmt.

In dem aktiven Bereich 21 und dem weiteren aktiven Bereich 27 ist ein Tunnelbereich 28 ausgeführt, der wie im Zusammenhang mit Figur 5 beschrieben ausgebildet sein kann. Im Unterschied zu dem im Zusammenhang mit Figur 5 beschriebenen Ausführungsbeispiel sind der aktive Bereich 21 und der weitere aktive Bereich 27 vergleichsweise weit voneinander entfernt. Mittels der Feldformungsschichten 22 beziehungsweise der weiteren Feldformungsschichten 23 sind die in dem aktiven Bereich 21 beziehungsweise weiteren aktiven Bereich 27 erzeugten Strahlungen voneinander entkoppelt.

Die aktiven Bereiche 21 und 27 können also weitgehend unabhängig voneinander kohärente Strahlung erzeugen. Für eine weitergehende Trennung der optischen Moden kann von dem dargestellten Ausführungsbeispiel abweichend zwischen der Feldformungsschicht 22 und der weiteren Feldformungsschicht 23 eine weitere Mantelschicht angeordnet sein. Diese weitere Mantelschicht weist zweckmäßigerweise einen Brechungsindex auf, der kleiner ist als der Brechungsindex der Feldformungsschichten 22 und der weiteren Feldformungsschichten 23.

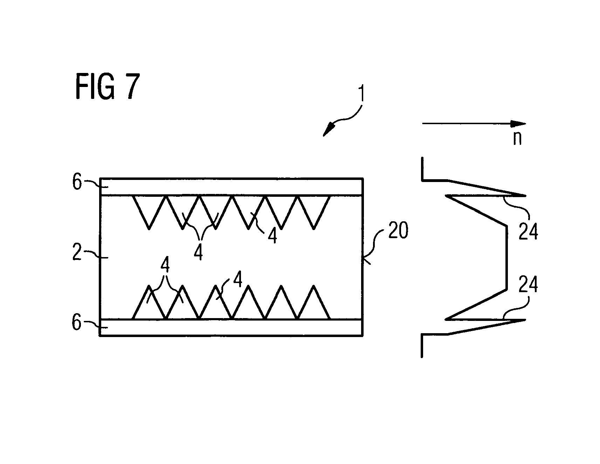

Ein fünftes Ausführungsbeispiel für ein strahlungsemittierendes Bauelement ist in Figur 7 schematisch in Aufsicht dargestellt. Die vertikale Struktur des Halbleiterkörpers mit der Halbleiterschichtenfolge kann hierbei wie in den im Zusammenhang mit den Figuren 4A bis Figur 6 beschriebenen Ausführungsbeispielen ausgeführt sein. Weiterhin ist qualitativ der Verlauf des zugehörigen Brechungsindexprofils dargestellt.

Der Halbleiterkörper 2 weist Ausnehmungen 4 auf, die sich senkrecht zu der Hauptabstrahlungsrichtung der aus der Seitenfläche 20 austretenden Strahlung in den Halbleiterkörper 2 hinein erstrecken. Die Ausnehmungen 4 können zumindest teilweise mit einem Füllmaterial befüllt sein, das vorzugsweise einen geringeren Brechungsindex aufweist als der Halbleiterkörper 2.

Von außerhalb des Halbleiterkörpers 2 aus gesehen verjüngen sich die Ausnehmungen mit zunehmender Tiefe. Auf diese Weise kann ein Brechungsindexprofil ausgebildet werden, das bei Mittelung entlang der Hauptabstrahlungsrichtung im Bereich der Ausnehmungen 4 zum Rand des Halbleiterkörpers 2 hin abnimmt. Die Ausnehmungen 4 erstrecken sich von gegenüberliegenden Seiten des Halbleiterkörpers 2 in den Halbleiterkörper hinein. Auf diesen Seiten ist jeweils eine Randschicht 6 angeordnet, deren Brechungsindex mit zunehmendem Abstand vom Halbleiterkörper 2 abnimmt. Davon abweichend kann auch eine Randschicht mit einem konstanten Brechungsindexverlauf vorgesehen sein.

Die Randschichten 6 enthalten vorzugsweise ein dielektrisches Material, beispielsweise ein Oxid, etwa Siliziumoxid oder Titanoxid, ein Nitrid, etwa Siliziumnitrid oder ein Oxinitrid, etwa Siliziumoxinitrid. Die Randschichten können auch jeweils mehrschichtig ausgeführt sein, wobei die Brechungsindizes der Teilschichten mit zunehmendem Abstand vom Halbleiterkörper abnehmen.

Zwischen dem Halbleiterkörper und den Randschichten 6 ist jeweils ein sprunghafter Übergang 24 ausgebildet, an dem der Brechungsindex vom Inneren des Halbleiterkörpers 2 aus gesehen sprunghaft ansteigt. Der sprunghafte Übergang ist also an einer Grenzfläche zwischen dem Halbleiterkörper und einer an diesen angrenzenden Schicht ausgebildet.

Auf diese Weise kann entlang einer Richtung, die senkrecht zu der Hauptabstrahlungsrichtung und senkrecht zur Abscheiderichtung der Halbleiterschichten des Halbleiterkörpers 2 ein weiteres Brechungsindexprofil ausgebildet werden. Mittels dieses weiteren Brechungsindexprofils kann das Nahfeld entlang dieser Richtung derart geformt werden, dass das aus dem Nahfeld resultierende Fernfeld entlang dieser Richtung einer vorgegebenen Abstrahlcharakteristik entspricht.

So kann das strahlungsemittierende Bauelement derart ausgeführt werden, dass die Abstrahlcharakteristik im Fernfeld entlang zweier zueinander senkrecht stehenden Achsen einem vorgegebenen Verlauf entspricht oder zumindest nahe kommt.

## Patentansprüche

1. Strahlungsemittierendes Bauelement mit einem Halbleiterkörper mit einer Halbleiterschichtenfolge, der einen zur Erzeugung von Strahlung vorgesehenen aktiven Bereich (21) und Feldformungsschichten (22) aufweist, wobei

   - der aktive Bereich zwischen den Feldformungsschichten angeordnet ist;
   - das strahlungsemittierende Bauelement eine Hauptabstrahlungsrichtung aufweist und senkrecht zu der Hauptabstrahlungsrichtung ein Brechungsindexprofil gebildet ist; und
   - auf der dem aktiven Bereich (21) abgewandten Seite der Feldformungsschichten (22) jeweils eine Mantelschicht (26) angeordnet ist, wobei die Mantelschichten (26) einen Brechungsindex aufweisen, der kleiner ist als der Brechungsindex der Feldformungsschichten (22);
   **dadurch gekennzeichnet, dass**
   - die Feldformungsschichten (22) jeweils einen Teilbereich (221) und einen direkt an den Teilbereich angrenzenden weiteren Teilbereich (222) aufweisen, wobei der Brechungsindex über den gesamten Teilbereich (221) und über den gesamten weiteren Teilbereich (222) jeweils mit zunehmendem Abstand vom aktiven Bereich (21) kontinuierlich abnimmt; und
   - das Brechungsindexprofil zwischen dem Teilbereich (221) und dem weiteren Teilbereich (222) jeweils einen sprunghaften Übergang aufweist, an dem der Brechungsindex vom aktiven Bereich (21) aus gesehen zunimmt.

2. Strahlungsemittierendes Bauelement nach Anspruch 1,
   bei dem die Abstrahlcharakteristik im Fernfeld (100) in einer linearen Skalierung einen Intensitätsverlauf als Funktion eines Winkels zur Hauptabstrahlungsrichtung aufweist, dem ein sich unter einer Kurve des Intensitätsverlaufs erstreckendes Rechteck mit maximaler Fläche (101) zugeordnet ist, das mindestens 50% der Gesamtfläche unter der Kurve des Intensitätsverlaufs des Fernfelds ausfüllt.

3. Strahlungsemittierendes Bauelement nach Anspruch 1,
   bei dem die Abstrahlcharakteristik im Fernfeld (100) in einer linearen Skalierung einen Intensitätsverlauf als Funktion eines Winkels zur Hauptabstrahlungsrichtung aufweist, dem ein sich unter einer Kurve des Intensitätsverlaufs erstreckendes Rechteck mit maximaler Fläche (101) zugeordnet ist, das mindestens 60% der Gesamtfläche unter der Kurve des Intensitätsverlaufs des Fernfelds ausfüllt.

4. Strahlungsemittierendes Bauelement nach einem der Ansprüche 1 bis 3,
   bei dem das Brechungsindexprofil senkrecht zu einer Haupterstreckungsrichtung der Halbleiterschichten des Halbleiterkörpers (2) verläuft.

5. Strahlungsemittierendes Bauelement nach einem der Ansprüche 1 bis 4,
   das senkrecht zur Hauptabstrahlungsrichtung und senkrecht zu dem Brechungsindexprofil ein weiteres Brechungsindexprofil aufweist, das mittels Ausnehmungen (4) gebildet ist, die sich entlang des weiteren Brechungsindexprofils in den Halbleiterkörper (2) hinein erstrecken.

6. Strahlungsemittierendes Bauelement nach einem der Ansprüche 1 bis 5,
   das einen weiteren aktiven Bereich (27) umfasst, der zur Erzeugung von Strahlung vorgesehen ist.

7. Strahlungsemittierendes Bauelement nach Anspruch 6,
   bei dem zwischen dem aktiven Bereich (21) und dem weiteren aktiven Bereich (27) ein Tunnelbereich (28) ausgebildet ist und bei dem die im aktiven Bereich (21) erzeugte Strahlung und die im weiteren aktiven Bereich (27) erzeugte Strahlung eine gemeinsame transversale optische Mode aufweisen und der Tunnelbereich (28) in einem Knoten der transversalen optischen Mode angeordnet ist.

**8.** Strahlungsemittierendes Bauelement nach Anspruch 6 oder 7,
bei dem einer der sprunghaften Übergänge (24) zwischen dem aktiven Bereich (21) und dem weiteren aktiven Bereich (27) angeordnet ist.

**9.** Strahlungsemittierendes Bauelement nach Anspruch 6,
bei dem beidseits des weiteren aktiven Bereichs (27) weitere Feldformungsschichten (23) angeordnet sind, wobei das Brechungsindexprofil beidseits des weiteren aktiven Bereichs jeweils einen weiteren sprunghaften Übergang (25) aufweist, an dem jeweils der Brechungsindex vom weiteren aktiven Bereich (27) aus gesehen zunimmt.

**Claims**

**1.** Radiation-emitting component comprising a semiconductor body having a semiconductor layer sequence, which has an active region (21) provided for generating radiation and field-shaping layers (22),
wherein

- the active region is arranged between the field-shaping layers;
- the radiation-emitting component has a main emission direction and a refractive index profile is formed perpendicular to the main emission direction;
and
- in each case one cladding layer (26) is arranged on that side of the field-shaping layers (22) which is remote from the active region (21), wherein the cladding layers (26) have a refractive index which is less than the refractive index of the field-shaping layers (22);
**characterized in that**
- the field-shaping layers (22) each have a subregion (221) and a further subregion (222), which directly adjoins the subregion, wherein the refractive index decreases continuously over the entire subregion (221) and over the entire further subregion (222) in each case as the distance from the active region (21) increases; and
- the refractive index profile between the subregion (221) and the further subregion (222) has in each case a sudden transition at which the refractive index increases, when viewed from the active region (21).

**2.** Radiation-emitting component according to Claim 1,
in which the emission characteristic in the far field (100), using a linear scaling, has an intensity profile as a function of an angle to the main emission direction, with a rectangle of maximum area (101) being assigned to said intensity profile, which rectangle extends below a curve of the intensity profile and fills at least 50% of the total area beneath the curve of the intensity profile of the far field.

**3.** Radiation-emitting component according to Claim 1,
in which the emission characteristic in the far field (100), using a linear scaling, has an intensity profile as a function of an angle to the main emission direction, with a rectangle of maximum area (101) being assigned to said intensity profile, which rectangle extends below a curve of the intensity profile and fills at least 60% of the total area beneath the curve of the intensity profile of the far field.

**4.** Radiation-emitting component according to one of Claims 1 to 3,
in which the refractive index profile extends perpendicular to a main direction of extent of the semiconductor layers of the semiconductor body (2).

**5.** Radiation-emitting component according to one of Claims 1 to 4,
which has a further refractive index profile perpendicular to the main emission direction and perpendicular to the refractive index profile, said further refractive index profile being formed by means of recesses (4), which extend along the further refractive index profile into the semiconductor body (2).

**6.** Radiation-emitting component according to one of Claims 1 to 5,
which comprises a further active region (27), which is provided for generating radiation.

**7.** Radiation-emitting component according to Claim 6,
in which a tunnel region (28) is formed between the active region (21) and the further active region (27), and in which the radiation generated in the active region (21) and the radiation generated in the further active region (27) have a common transverse optical mode, and the tunnel region (28) is arranged in a node of the transverse optical mode.

8. Radiation-emitting component according to Claim 6 or 7,
   in which one of the sudden transitions (24) is arranged between the active region (21) and the further active region (27).

9. Radiation-emitting component according to Claim 6,
   in which further field-shaping layers (23) are arranged on both sides of the further active region (27), wherein the refractive index profile on both sides of the further active region has in each case one further sudden transition (25), at which in each case the refractive index increases, when viewed from the further active region (27).


**Revendications**

1. Composant émettant un rayonnement, présentant un corps semi-conducteur doté d'une succession de couches semi-conductrices qui présente une partie active (21) prévue pour former le rayonnement et des couches (22) de formation de champ,
   la couche active étant disposée entre les couches de formation de champ,
   le composant émettant un rayonnement présentant une direction principale de rayonnement et un profil d'indices de réfraction étant formé perpendiculairement à la direction principale de rayonnement, et
   une couche d'enveloppe (26) étant formée sur le côté des couches (22) de formation de champ non tourné vers la partie active (21),
   les couches d'enveloppe (26) présentant un indice de réfraction plus petit que l'indice de réfraction des couches (22) de formation de champ,
   **caractérisé en ce que**
   les couches (22) de formation de champ présentent toutes une partie (221) et une autre partie (222) directement adjacente à cette partie, l'indice de réfraction diminuant de manière continue avec l'augmentation de la distance par rapport à la couche active (21) sur la totalité de la partie (221) et sur la totalité de l'autre partie (222) et
   **en ce que** le profil d'indices de réfraction présente entre la partie (221) et l'autre partie (222) une transition brusque sur laquelle l'indice de réfraction augmente depuis la partie active (21).

2. Composant émettant un rayonnement selon la revendication 1, dans lequel la caractéristique de rayonnement dans le champ lointain (100) présente dans un échelonnage linéaire une évolution d'intensité en fonction de l'angle par rapport à la direction principale de rayonnement auquel est associé un rectangle de surface maximale (101) qui s'étend en dessous d'une courbe de l'évolution d'intensité qui remplit au moins 50 % de la surface totale située en dessous de la courbe de l'évolution d'intensité du champ lointain.

3. Composant émettant un rayonnement selon la revendication 1, dans lequel la caractéristique de rayonnement dans le champ lointain (100) présente dans un échelonnage linéaire une évolution d'intensité en fonction de l'angle par rapport à la direction principale de rayonnement auquel est associé un rectangle de surface maximale (101) qui s'étend en dessous d'une courbe de l'évolution d'intensité qui remplit au moins 60 % de la surface totale située en dessous de la courbe de l'évolution d'intensité du champ lointain.

4. Composant émettant un rayonnement selon l'une des revendications 1 à 3, dans lequel le profil d'indices de réfraction s'étend perpendiculairement à la direction d'extension principale des couches semi-conductrices du corps semi-conducteur (2).

5. Composant émettant un rayonnement selon l'une des revendications 1 à 4, qui présente perpendiculairement à la direction principale de rayonnement et perpendiculairement au profil d'indices de réfraction un autre profil d'indices de réfraction formé de découpes (4) qui s'étendent dans le corps semi-conducteur (2) le long de l'autre profil d'indices de réfraction.

6. Composant émettant un rayonnement selon l'une des revendications 1 à 5, qui comporte une autre partie active (27) prévue pour former du rayonnement.

7. Composant émettant un rayonnement selon la revendication 6, dans lequel entre la partie active (21) et l'autre partie active (27) est formée une partie (28) formant tunnel et dans lequel le rayonnement formé dans la partie active (21) et le rayonnement formé dans l'autre partie active (27) présente un mode optique transversal commun, la partie (28) formant tunnel étant disposée dans un noeud du mode optique transversal.

8. Composant émettant un rayonnement selon les revendications 6 ou 7, dans lequel une des transitions brusques (24) entre la partie active (21) et l'autre partie active (27) est disposée.

9. Composant émettant un rayonnement selon la revendication 6, dans lequel d'autres couches (23) de formation de champ sont disposées des deux côtés de l'autre partie active (27), le profil d'indices de réfraction des deux côtés de l'autre partie active présentant chaque fois une autre transition brusque (25) sur laquelle l'indice de réfraction augmente depuis l'autre partie active (27).

## FIG 1A

## FIG 1B

FIG 1C

FIG 1D

FIG 1E

## FIG 2A

## FIG 2B

FIG 2C

FIG 2D

# FIG 2E

# FIG 3

# FIG 4A

FIG 4B

FIG 4C

FIG 5

FIG 6

FIG 7

**IN DER BESCHREIBUNG AUFGEFÜHRTE DOKUMENTE**

**In der Beschreibung aufgeführte Patentdokumente**

- US 5815521 A

- JP 5251813 A

**In der Beschreibung aufgeführte Nicht-Patentliteratur**

- **S. T. YEN et al.** *IEEE Journal of Quantum Electronics,* Januar 1996, vol. 32 (1